# EUROPÄISCHE PATENTSCHRIFT

(11) **EP 2 594 928 B1**
(45) Veröffentlichungstag und Bekanntmachung des Hinweises auf die Patenterteilung: **27.04.2016**
(21) Anmeldenummer: 12007744.1
(22) Anmeldetag: 15.11.2012
(51) Int. Cl.: G01N 27/414, H01L 23/485, H01L 21/56, H01L 25/00, H01L 23/482

(54) **Halbleiter-Gassensor**
Semiconductor gas sensor
Capteur de gaz à semi-conducteur

(30) Priorität: 21.11.2011 DE 102011118930
(43) Veröffentlichungstag der Anmeldung: 22.05.2013
(73) Patentinhaber: Micronas GmbH, 79108 Freiburg (DE)
(72) Erfinder: Wilbertz, Christoph, 79194 Gundelfingen (DE); Kolleth, Tobias, 79108 Freiburg (DE); Frerichs, Heinz-Peter, 79271 St. Peter (DE)
(74) Vertreter: Koch Müller Patentanwaltsgesellschaft mbH

(56) Entgegenhaltungen:
- EP-A1- 0 616 363
- EP-A1- 1 879 023
- DE-A1- 19 849 932
- DE-A1-102005 008 051
- DE-C2- 4 239 319

## Beschreibung

Die Erfindung betrifft ein Halbleiter-Gassensor gemäß dem Oberbegriff des Patentanspruchs 1.

Aus der DE 100 36 178 A1 ist ein FET-Feuchtesensor bekannt. Hierbei wird die Leitfähigkeit des Kanalgebietes durch ein Suspended Gate (SG) moduliert. Des Weiteren sind aus der DE 42 39 319 C2, der DE 10 2005 008 051 A und der EP 1 103 808 B1 jeweils SGFET Gassensoren bekannt.

Des Weiteren sind aus der DE 199 07 168 C1, der US 5 545 589 A, der US 5 137 461 A und der US 5 432 675 A weitere Befestigungsvorrichtungen bekannt. Aus der DE 198 49 932 A1 und der EP 0 616 363 A1 und der EP 1 879 023 A1 sind weitere Steuerelektroden mit halbleitenden Substraten bekannt, wobei eine kraftschlüssige Verbindung zwischen der Steuerelektrode und dem jeweiligen Substrat hergestellt ist.

Ein gemeinsames Kennzeichen derartiger MOS-Transistoren mit einer von dem Kanalbereich durch einen Luftspalt beanstandeten Steuerelektrode ist, dass die Steuerelektrode und der Halbleiterkörper im Allgemeinen nicht einstückig ausgebildet sind. Hierdurch muss die Steuerelektrode mittels Verbindungsmittel mit dem zugehörigen Transistorbereich verbunden werden. Des Weiteren ist die Steuerelektrode elektrisch anzuschließen.

Vor diesem Hintergrund besteht die Aufgabe der Erfindung darin, einen Halbleiter-Gassensor anzugeben, der den Stand der Technik weiterbildet.

Die Aufgabe wird durch einen Halbleiter-Gassensor mit den Merkmalen des Patentanspruchs 1 gelöst. Vorteilhafte Ausgestaltungen der Erfindung sind in den Unteransprüchen enthalten.

Gemäß dem Gegenstand der Erfindung wird ein Halbleiter-Gassensor auf der Basis eines integrierten Feldeffekttransistors bereitgestellt mit einen Halbleiterkörper mit einer an der Oberfläche des Halbleiterkörpers ausgebildeten Passivierungsschicht, wobei der Halbleiter-Gassensor eine durch einen Spalt von einen Kanalbereich getrennte gassensitive Steuerelektrode aufweist und als Suspended Gate Feldeffekttransistor (SGFET) ausgebildet ist, oder die Steuerelektrode als eine erste Platte eines Kondensators mit Spalt angeordnet ist und eine zweite Platte des Kondensators mit einem Gate des als Capacitve Controlled ausgebildeten Feldeffekttransistors (CCFET) verbunden ist, und die Steuerelektrode eine Halbleiter-Trägerschicht mit einer aufliegenden Haftvermittlerschicht und einer auf der Haftvermittlerschicht aufliegenden gassensitiven Schicht aufweist, wobei die Steuerelektrode mit einem Referenzpotential verschaltet und die Oberfläche der gassensitiven Schicht (120) dem Kanalbereich (55) oder der zweiten Platte zugewandt ist, und des Weiteren ist ein Stützgebiet mit einer ersten Tragstruktur (70) mit einem ersten Auflagebereich (75) und einer zweiten Tragstruktur (80) mit einem zweiten Auflagebereich (85) vorgesehen, wobei auf der Oberfläche des Halbleiterkörpers ein Anschlussgebiet vorgesehen ist und das Stützgebiet an das Anschlussgebiet angrenzt, und das Anschlussgebiet einen ersten Anschlussbereich und einen zweiten Anschlussbereich aufweist und der erste Anschlussbereich eine die Passivierungsschicht durchdringende erste Ausformung umfasst und die erste Ausformung eine Bodenfläche mit einer mit dem Referenzpotential verschalten leitfähigen Schicht aufweist und der erste Anschlussbereich mit der Steuerelektrode mittels eines ersten Verbindungsmittels eine elektrische Verbindung und eine kraftschlüssige Verbindung aufweist und der zweiten Anschlussbereich mit der Steuerelektrode mittels eines zweiten Verbindungsmittels wenigstens eine kraftschlüssige Verbindung aufweist, und das erste Verbindungsmittel die Ausformung wenigstens teilweise ausfüllt und die Steuerelektrode mit der leitfähigen Schicht verbindet.

Es sei angemerkt, dass die dem Kanalbereich zugewandte Fläche der Steuerelektrode im Folgenden auch als Innenfläche bezeichnet wird, d.h. die gassensitive Schicht ist auf der Innenfläche angeordnet. Hierbei überdeckt die gassensitive Schicht wenigstens einen Teil vorzugsweise den gesamten Kanalbereich bei dem SGFET oder die Gegenelektrode, d.h. zweite Platte, bei dem CCFET in einem vorgegeben Abstand, wobei der Abstand die lichte Weite des Spaltes bestimmt. Die der Innenfläche gegenüberliegenden Fläche der Steuerelektrode wird als Außenfläche bzw. als Deckfläche bezeichnet. Des Weiteren wird dem Begriff Transistorgebiet ein Gebiet bezeichnet, welches den Sourcebereich, den Kanalbereich und den Drainbereich umfasst.

Ein Vorteil ist, dass die Steuerelektrode, die im Allgemeinen als Schichtstapel ausgebildet ist, mittels eines ersten Verbindungsmittels mit dem Halbleiterkörper nicht nur mechanisch, d.h. kraftschlüssig verbunden, sondern auch mittels des ersten Verbindungsmittels elektrisch mit einem Referenzpotential verschaltet ist. Untersuchungen haben gezeigt, dass eine elektrische Verschaltung mittels des ersten Verbindungsmittels eine zusätzliche elektrische Kontaktierung beispielsweise mittels eines Bonddrahtes ersetzen kann. Hierdurch lässt sich die Herstellung der Ausformung bereits auf der sogenannten Waferlevelebene durchführen und sich die Herstellung der Ausformung ohne Weiters in den Herstellungsprozess einer integrierten Schaltung einfügen. Die Herstellung der Gassensoren wird kostengünstiger und die Zuverlässigkeit der Gassensoren steigt. Des Weiteren verringert sich gegenüber einer Ausführung mit einem Bonddraht auf der Deckfläche bzw. Außenfläche der Steuerelektrode die Bauhöhe. Untersuchungen haben gezeigt, dass bereits eine geringe elektrische Leitfähigkeit des ersten Verbindungsmittels ausreicht, um die Steuerelektrode elektrisch anzuschließen. Es ist bevorzugt, den Anschlusswiderstand unterhalb 50 MOhm, höchst vorzugsweise unterhalb 1 MOhm auszubilden. Es ist vorteilhaft, das erste Verbindungsmittel und oder das zweite Verbindungsmittel gleichartig auszuführen und insbesondere als Leitkleber auszubilden. Hierbei ist es hinreichend, dass der Leitkleber oder wenigstens das erste Verbindungsmittel eine Leitfähigkeit oberhalb von 1 S/m aufweist.

Anders ausgedrückt, lässt sich der der SGFET oder der CGFET als ein integriertes Bauelement bezeichnen, wobei das erste Verbindungsmittel und oder das zweite Verbindungsmittel ein erster Teil und die Steuerelektrode ein zweiter Teil eines unterhalb der Passivierungsschicht ausgebildeten dritten Teil eines integrierten Bauelementes darstellt. Zwischen den unterschiedlichen Teilen besteht eine elektrische Signalverbindung, d. h. die einzelnen Teile des integrierten Bauelements stehen untereinander in einer elektrischen Wirkverbindung und bilden erst gemeinsam das vollständige Bauelement aus.

In einer Weiterbildung Ist die Steuerelektrode in Richtung des Normalenvektors der Halbleiteroberfläche von dem Anschlussgebiet beabstandet und überdeckt das Anschlussgebiet. Hierbei ist der Abstand zwischen der Steuerelektrode und des Anschlussgebietes insbesondere durch die Höhe der ersten Tragstruktur und durch die Höhe der zweiten Tragstruktur bestimmt, wobei es bevorzugt ist, die Höhe der ersten Tragstruktur gleich groß wie die Höhe der zweiten Tragstruktur auszubilden. Unter der Höhe der Tragstruktur wird hierbei die Seitenlänge der jeweiligen Tragstruktur entlang des Normalenvektors verstanden. In einer besonders bevorzugten Ausführungsform umfassen der erste Auflageberelch und / oder der zweite Auflagebereich jeweils ein Plateau, wobei die Plateaus an der Oberfläche von der Passivierungsschicht ausbildet sind und die Steuerelektrode auf den Plateaus aufliegt. Hierbei ist es bevorzugt, dass die Steuerelektrode ausschließlich auf den Plateaus aufliegt und von dem ersten Verbindungsmittel und / oder dem zweiten Verbindungsmittel sowohl ausschließlich gehalten wird und ausschließlich elektrisch mit dem Referenzpotential mittels eines der Verbindungsmittel verbunden ist.

Gemäß einer Weiterbildung weist zusätzlich zu dem ersten Anschlussbereich auch der zweite Anschlussbereich eine die Passivierungsschicht durchdringende zweite Ausformung mit jeweils einer Bodenfläche auf. Des Weiteren ist es bevorzugt, an der Bodenfläche der zweiten Ausformung eine leitfähige Schicht auszubilden. Es ist bevorzugt, dass das zweite Verbindungsmittel die zweite Ausformung wenigstens teilweise ausfüllt und zusätzlich zu der mechanischen Verbindung auch eine elektrische Verbindung zwischen der Steuerelektrode und dem Referenzpotential herstellt, indem das zweite Verbindungsmittel, welches eine elektrische Leitfähigkeit aufweist, die Steuerelektrode mit der leitfähigen Schicht verbindet. Ferner ist es bevorzugt, die beiden Ausformungen grabenförmig oder lochförmig auszubilden und die Ausformungen durch die dielektrischen Schichten der einzelnen Leiterbahnebenen hindurchzuführen. Gemäß einer alternativen Ausführungsform ist es bevorzugt, ein Teil einer Seitenfläche der beiden Ausformungen mit einer leitfähigen Schicht auszubilden. Untersuchungen haben gezeigt, dass sich innerhalb der Ausformung sowohl eine Leiterbahnschicht als auch eine siliziumhaltige Schicht, vorzugsweise eine dotierte Polysiliziumschicht mit einer aufliegenden Silizidschlcht eignet. Hierbei Ist es vorteilhaft, die Silizidschicht als Wolframsilizid auszubilden. Ferner ist es bevorzugt, dass das erste Verbindungsmittel und oder das zweite Verbindungsmittel die erste Ausformung bzw. die zweite Ausformung vollständig ausfüllt.

Gemäß einer bevorzugten Ausführungsform ist auf der Bodenfläche eine, vorzugsweise eine Vielzahl von kegelstumpfartigen Erhöhungen, ausgebildet. Gemäß einer Weiterbildung sind die Erhöhungen leitfähig ausgebildet, insbesondere ist es bevorzugt, die Erhöhungen als Wolframplugs auszubilden. Ein Vorteil der Erhöhungen ist es, dass das erste Verbindungsmittel und oder das zweite Verbindungsmittel eine besonders zuverlässige mechanische und / oder elektrische Verbindung mit der Ausformung und insbesondere mit der Bodenfläche ausbilden. Anders ausgedrückt die Wolframplugs bzw. die Erhöhungen vergrößern die Oberfläche die durch die beiden Verbindungsmittel benetzbar ist.

Gemäß einer bevorzugten Ausführungsform sind das erste Verbindungsmittel und das zweite Verbindungsmittel ausschließlich unterhalb der Steuerelektrode und an der Außenseite der Steuerelektrode angeordnet. Hierdurch wird die Außenfläche der Steuerelektrode nicht von einem der beiden Verbindungsmittels umfasst und die Bauhöhe des Gassensors verringert sich.

In einer weiteren Ausführungsform ist es besonders vorteilhaft, dass der erste Anschlussbereich unmittelbar an die erste Tragstruktur angrenzt. Hierdurch wird wenig Fläche an der Halbleiteroberfläche zur Ausbildung des Gassensors benötigt. Ferner ist es vorteilhaft, den SGFET oder den CCFET von einer ebenfalls auf dem Halbleiterkörper angeordneten integrierten Schaltung anzusteuern und die Signale des SGFET mittels der integrierten Schaltung auszuwerten.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnittsansicht auf einen SGFET Halbleiter-Gassensor,
- Figur 2: eine Querschnittsansicht auf einen CCFET Halbleiter-Gassensor,
- Figur 3: eine detaillierte Ansicht auf einen Ausschnitt der Figur 1 und der Figur 2 gemäß einer ersten Ausführungsform,
- Figur 4: eine detaillierte Ansicht auf einen Ausschnitt der Figur 1 und der Figur 2 gemäß einer zweiten Ausführungsform.

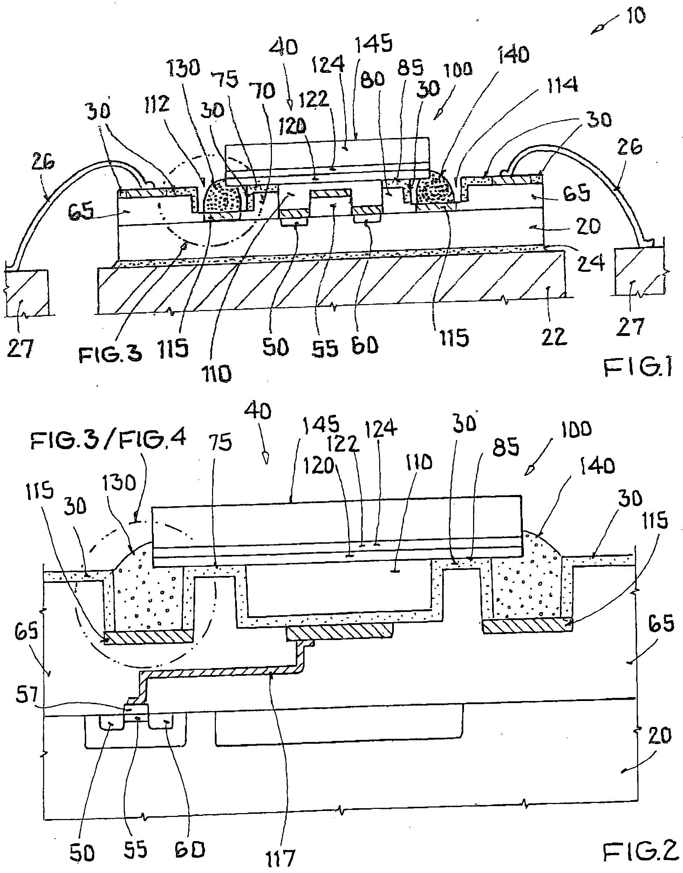

Die Abbildung der Figur 1 zeigt eine Querschnittsansicht auf einen SGFET Halbleiter-Gassensor, aufweisend ein Schaltkreisgehäuse - nicht dargestellteinen innerhalb des Schaltkrelsgehäuses integrierten Halbleiter-Gassensor 10 mit einem Halbleiterkörper 20 mit einer an der Oberfläche ausgebildeten Passivierungsschicht 30 und einen in dem Halbleiterkörper 20 ausgebildeten integrierten Suspended Gate Feldeffekttransistor 40, auch kurz als SGFET bezeichnet, mit einem Transistorgebiet, mit einem Sourcebereich 50, einem Kanalbereich 55 und einem Drainbereich 60. Der Halbleiterkörper 20 ist auf einem Träger 22, auch Leadframe genannt, mittels einer Klebeschicht 24 fixiert. Auf der Oberfläche des Halbleiterkörpers 20 sind in der obersten Leiterbahnebene 25 Metallflächen, sogenannte Pads, ausgebildet. Das jeweilige Pad wird mittels eines zugeordneten Bonddrahtes 26 mit einem zugeordneten Pin 27 elektrisch mit externen, d.h. außerhalb des Schaltkreisgehäuses liegenden elektrischen Anschlüssen verbunden. Die oberste Leiterbahnebene 25 ist außer bei den Pads mit der Passivierungsschicht 30 abgedeckt. Unterhalb der Passivierungsschicht 30 sind je nach Anzahl der Leiterbahnebenen mehrere Oxidschichten 65 ausgebildet, wobei innerhalb der Oxidschichten ausgebildete Leiterbahnebenen nicht dargestellt sind.

Der SGFET weist ein Stützgebiet mit einer ersten Tragstruktur 70 mit einem ersten Auflagebereich 75 und einer zweiten Tragstruktur 80 mit einem zweiten Auflagebereich 85 auf, wobei das Transistorgebiet auf der Oberfläche des Halbleiterkörpers 20 innerhalb des Stützgebietes angeordnet ist. Der erste Auflagebereich 75 und der zweite Auflagebereich 85 sind entlang des Normalenvektors der Halbleiteroberfläche oberhalb des Transistorgebietes angeordnet und von dem Transistorgebiet beabstandet.

Über dem Kanalbereich 55 ist eine Steuerelektrode 100 vorgesehen, wobei die Steuerelektrode 100 den Kanalbereich 55 überspannt und auf dem ersten Auflagebereich 75 und dem zweiten Auflagebereich 85 aufliegt und zwischen dem Kanalbereich 55 und der Steuerelektrode 100 ein Spalt 110 ausgebildet wird.

Im weiteren Verlauf überdeckt die Steuerelektrode 100 teilweise ein an der Oberfläche des Halbleiterkörpers 20 ausgebildetes Anschlussgebiet, wobei das Anschlussgebiet einen ersten Anschlussbereich mit einer ersten Ausformung 112 und einen zweiten Anschlussbereich mit einer zweiten Ausformung 114 umfasst. Die beiden Ausformungen 112, 114 sind vorzugsweise als graben- oder lochartige Strukturen ausgebildet und durchgreifen vorliegend die auf der Oberfläche des Halbleiterkörpers 20 angeordnete Passivierungsschicht 30 und die darunterliegenden Oxidschichten 65. An dem Boden der beiden Ausformungen 112, 114 ist jeweils eine dotierte elektrisch leitfähige Polysiliziumschicht 115 mit einer Silizidschicht ausgebildet.

Ferner ist die Steuerelektrode 100 in Richtung des Normalenvektors der Oberfläche des Halbleiterkörpers 20 von dem Anschlussgebiet beabstandet. Des Weiteren weist die Steuerelektrode 100 auf der dem Kanalbereich 55 zugewandten Fläche eine gassensitive Schicht 120 auf. Die gassensitive Schicht 120 ist auf einer Haftvermittlerschicht 122 mit der einer im Allgemeinen aus einem Halbleitermaterial ausgebildeten Trägermaterial 124 verbunden.

Das Stützgebiet ist auf der Oberfläche des Halbleiterkörpers 20 innerhalb des Anschlussgebletes angeordnet, wobei das Anschlussgebiet einen ersten Anschlussbereich mit der ersten Ausformung 112 und einen zweiten Anschlussbereich mit der zweiten Ausformung 114 aufweist und der erste Anschlussbereich mit der Steuerelektrode 100 mittels eines ersten Verbindungsmittels 130, welches vorzugsweise als Leitkleber ausgebildet ist, sowohl einen elektrischen Kontakt bzw. Verbindung als auch eine kraftschlüssige Verbindung aufweist. Hierdurch ist die Steuerelektrode 100 mit einem Referenzpotential - nicht dargestellt- verschaltet.

Des Weiteren ist der zweite Anschlussbereich mit der Steuerelektrode 100 mittels eines zweiten Verbindungsmittels 140 verbunden. Es ist vorteilhaft, wenn das zweite Verbindungsmittel 140 mit dem ersten Verbindungsmittel 130 identisch ist. Hierdurch lässt sich der Herstellungsprozess des Gassensors vereinfachen und Herstellungskosten einsparen. Es sei angemerkt, dass es gemäß einer alternativen Ausführung für das zweite Verbindungsmittel 140 auch hinreichend ist, nur eine kraftschlüssige Verbindung auszubilden. Des Weiteren ist es bevorzugt, das erste und das zweite Verbindungsmittel 130, 140 unterhalb der Steuerelektrode 100 und an der Außenseite der Steuerelektrode 100 anzuordnen, jedoch nicht an der Außenfläche 145.

Die Abbildung der Figur 2 zeigt eine Querschnittsansicht auf einen CCGFET Halbleiter-Gassensor dargestellt. Im Folgenden werden nur die Unterschiede zu der Abbildung der Figur 1 erläutert. Das Transistorgebiet ist nicht unterhalb der Steuerelektrode 100 innerhalb des Spaltes 110, sondern an einer anderen Stelle des Halbelterkörpers 20 ausgebildet. Die gassensitive Schicht der Steuerelektrode 100 stellt nun eine erste Platte eines Kondensators dar. Die zweite Platte des Kondensators ist unterhalb der ersten Platte in einem Bodenbereich des Spaltes 110 ausgebildet und mittels einer Leiterbahn 117 mit einem Gate 57 des Feldeffekttransistors verschaltet. Des Weiteren ist die zweite Platte mit der Passivierungsschicht 30 abgedeckt und hierdurch vor Umgebungseinflüssen geschützt. Ändert sich nun die Austrittsarbeit an der ersten Platte des Kondensators, so ändert sich hierdurch auch die Spannung an dem Gate 57 des Feldeffekttransistors und in der Folge die Leitfähigkelt in dem Kanalbereich 55. Die Gatespannung des Feldeffekttransistors wird also kapazitiv kontrolliert.

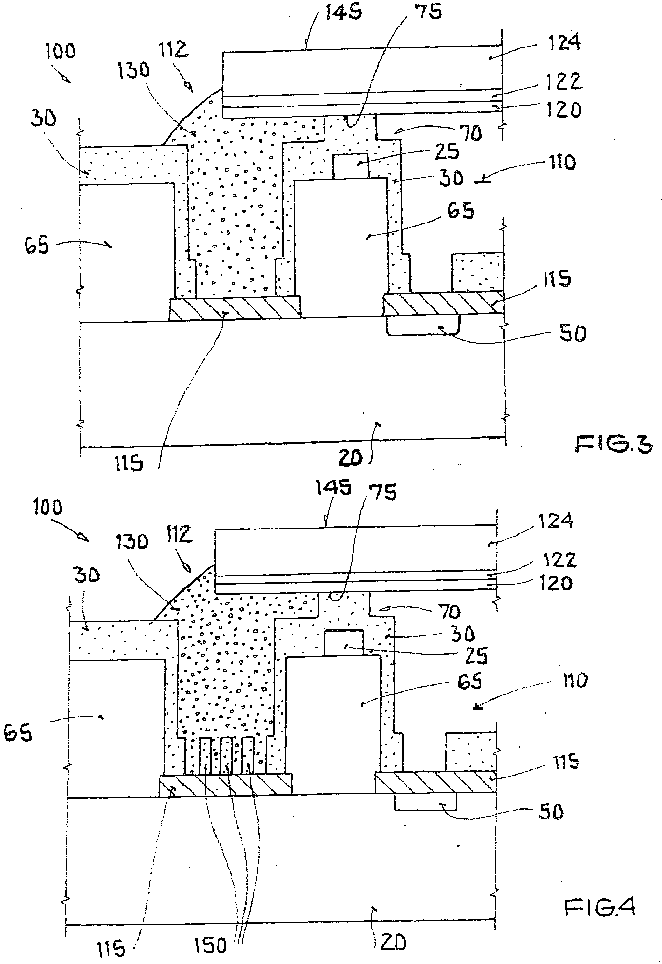

In der Abbildung der Figur 3 ist eine detaillierte Ansicht auf einen Ausschnitt der Figur 1 und der Figur 2 gemäß einer ersten Ausführungsform dargestellt. Im Folgenden werden nur die Unterschiede zu den Ausführungsformen in den vorstehenden Figuren erläutert. Es versteht sich, dass sich die nachfolgend erläuterten Ausführungsformen ohne Weiteres auf den zweiten Anschlussbereich übertragen lassen. Die Steuerelektrode 100 überdeckt die erste Ausformung 112 teilweise. Zur Herstellung der ersten Ausformung 112 werden die Oxidschichten 65 bis auf die unterhalb der Oxidschicht angeordnete elektrisch leitfähige Polysiliziumschicht 115 vorzugsweise mittels eines anisotropen Ätzprozesses entfernt. An der Seitenflächen der Ausformung 112 ist die Passivierungsschicht 30 ausgebildet. Hierdurch wird ersichtlich, dass die erste Ausformung 112 mittels eines ersten Ätzprozesses vor der Abscheidung der Passivierungsschicht aufgebracht worden ist. Anschließend wird die Polysiliziumschicht 115 mit einem sogenannten Padfensterätzprozess in dem Bodenbereich der Ausformung 112 freigelegt. In einer nicht dargestellten alternativen Ausführungsform lässt sich die Ausformung 112 auch nach dem Abscheiden der Passivierungsschicht 30 herstellen. Hierbei ist an den Seitenflächen der Ausformung keine Passivierungsschicht 30 ausgebildet.

Unmittelbar an der ersten Ausformung 112 bzw. an den ersten Anschlussbereich grenzt die erste Tragstruktur 70. Die erste Tragstruktur 70 weist an der Oberfläche den tafelbergartig erhöhten Auflagebereich 75 auf. Die Erhöhung wird durch die Ausbildung einer Leiterbahn in der obersten Leiterbahnebene 25 unterhalb der Passivierungsschicht 30 bewirkt und bildet mit der auf dem Auflagebereich 75 formschlüssig aufliegenden Steuerelektrode 100 einen Falz aus. Um die Steuerelektrode 100 zuverlässig sowohl kraftschlüssig als auch elektrisch mit dem Halbleiterkörper 20 zu verbinden, füllt das erste Verbindungsmittel 130 die erste Ausformung 112 und den Falz vollständig aus. Des Weiteren wird von dem ersten Verbindungsmittel 130 auch ein Teil der Seitenfläche der Steuerelektrode 100 und ein Teil der Passivierungsschicht 30 auf der Oberfläche des Halbleiterkörpers 20 umfasst. Hierdurch wird mittels des ersten Verbindungsmittels 130 eine sehr zuverlässige und haltbare Verbindung der Steuerelektrode 100 mit dem Halbleiterkörper 20 ausgebildet.

In der Abbildung der Figur 4 ist eine detaillierte Ansicht auf einen Ausschnitt der Figur 1 und der Figur 2 gemäß einer zweiten Ausführungsform dargestellt. Im Folgenden werden nur die Unterschiede zu den vorstehenden Figuren erläutert. Auf der Bodenfläche bzw. auf der Polysiliziumschicht 115 ist eine Vielzahl von kegelstumpfartigen Erhöhungen, die vorzugsweise als Wolframplugs 150 ausgebildet sind, angeordnet. Die Wolframplugs 150 bilden mit der Unterlage, die bevorzugt als Silizidschicht, höchst vorzugsweise als Wolframsilizidschicht ausgebildet ist, eine stoffschlüssige und kraftschlüssige Verbindung. Die Wolframplugs 150 sind jeweils mit dem ersten Verbindungsmittel 130 umhüllt. Hierdurch wird eine besonders feste und zuverlässige Verbindung zwischen dem ersten Verbindungsmittel 130 und dem Bodenbereich ausgebildet.

## Patentansprüche

1. Halbleiter-Gassensor (10) auf der Basis eines integrierten Feldeffekttransistors mit einen Halbleiterkörper (20) mit einer an der Oberfläche des Halbleiterkörpers (20) ausgebildeten Passivierungsschicht (30),
- der eine durch einen Spalt von einen Kanalbereich getrennte gassensitive Steuerelektrode aufweist und als Suspended Gate Feldeffekttransistor (SGFET) ausgebildet ist, oder
- die Steuerelektrode (100) als eine erste Platte eines Kondensators mit Spalt angeordnet ist und eine zweite Platte des Kondensators mit einem Gate des als Capacitve Controlled ausgebildeten Feldeffekttransistors (CCFET) verbunden ist, und
die Steuerelektrode (100) eine Halbleiter-Trägerschicht mit einer aufliegenden Haftvermittlerschicht (122) und einer auf der Haftvermittlerschicht aufliegenden gassensitiven Schicht (120) aufweist, und
- die Oberfläche der gassensitiven Schicht (120) dem Kanalbereich (55) oder der zweiten Platte zugewandt ist, und
- ein Stützgebiet mit einer ersten Tragstruktur (70) mit einem ersten Auflagebereich (75) und einer zweiten Tragstruktur (80) mit einem zweiten Auflagebereich (85) vorgesehen ist, wobei die Steuerelektrode (100) auf dem ersten Auflagebereich (75) aufliegt,
**dadurch gekennzeichnet, dass**
auf der Oberfläche des Halbleiterkörpers (20) ein Anschlussgebiet vorgesehen ist und das Stützgebiet an das Anschlussgebiet angrenzt, und das Anschlussgebiet einen ersten Anschlussbereich und einen zweiten Anschlussbereich aufweist und der erste Anschlussbereich eine die Passivierungsschicht (30) durchdringende erste Ausformung (112) umfasst und die erste Ausformung eine Bodenfläche mit einer mit einem Referenzpotential verschalteten leitfähigen Schicht (115) aufweist und der erste Anschlussbereich mit der Steuerelektrode (100) mittels eines ersten Verbindungsmittels (130) eine elektrische Verbindung und eine kraftschlüssige Verbindung aufweist und der zweiten Anschlussbereich mit der Steuerelektrode (100) mittels eines zweiten Verbindungsmittels (140) wenigstens eine kraftschlüssige Verbindung aufweist, und das erste Verbindungsmittel (130) die Ausformung wenigstens teilweise ausfüllt und die Steuerelektrode (100) mit der leitfähigen Schicht (115) verbindet.

2. Halbleiter-Gassensor (10) nach Anspruch 1, **dadurch gekennzeichnet, dass** die Steuerelektrode (100) in Richtung des Normalenvektors der Halbleiteroberfläche von dem Anschlussgebiet beabstandet ist und das Anschlussgebiet wenigstens teilweise überdeckt.

3. Halbleiter-Gassensor (10) nach Anspruch 1 oder Anspruch 2, **dadurch gekennzeichnet, dass** der zweite Anschlussbereich (140) eine die Passivierungsschicht (30) durchdringende zweite Ausformung (114) mit einer Bodenfläche aufweist und an der Bodenfläche eine leitfähige Schicht ausgebildet ist und das erste Verbindungsmittel (130) die Steuerelektrode (100) mit der leitfähigen Schicht elektrisch verbindet.

4. Halbleiter-Gassensor (10) nach Anspruch 3, **dadurch gekennzeichnet, dass** das auf der Bodenfläche eine kegelstumpfartige Erhöhung ausgebildet ist.

5. Halbleiter-Gassensor (10) nach Anspruch 4, **dadurch gekennzeichnet, dass** das auf der Bodenfläche eine Vielzahl von kegelstumpfartigen Erhöhungen ausgebildet sind.

6. Halbleiter-Gassensor (10) nach Anspruch 4 oder Anspruch 5, **dadurch gekennzeichnet, dass** die Erhöhung als Wolframplug (150) ausgebildet ist.

7. Halbleiter-Gassensor (10) nach einem der Ansprüche 3 bis 6, **dadurch gekennzeichnet, dass** die leitfähige Schicht Silizium enthält.

8. Halbleiter-Gassensor (10) nach einem der Ansprüche 3 bis 7, **dadurch gekennzeichnet, dass** die leitfähige Schicht aus einer dotierten Polysiliziumschicht (115) und einer Silizidschicht ausgebildet ist.

9. Halbleiter-Gassensor (10) nach einem der vorangehenden Ansprüche, **dadurch gekennzeichnet, dass** das erste Verbindungsmittel (130) und das zweite Verbindungsmittel (140) ein Leitkleber enthält.

10. Halbleiter-Gassensor (10) nach einem der vorangehenden Ansprüche, **dadurch gekennzeichnet, dass** das erste Verbindungsmittel (130) und das zweite Verbindungsmittel (140) ausschließlich unterhalb der Steuerelektrode (100) und an der Außenseite der Steuerelektrode (100) angeordnet ist.

11. Halbleiter-Gassensor (10) nach einem der vorangehenden Ansprüche, **dadurch gekennzeichnet, dass** der erste Anschlussbereich unmittelbar an die erste Tragstruktur (70) angrenzt.

12. Halbleiter-Gassensor (10) nach einem der Ansprüche 3 bis 11, **dadurch gekennzeichnet, dass** das erste Verbindungsmittel (130) und oder das zweite Verbindungsmittel (140) die erste Ausformung (112) und die zweite Ausformung (114) vollständig ausfüllt.

13. Halbleiter-Gassensor (10) nach einem der Ansprüche 1 bis 12, **dadurch gekennzeichnet, dass** der erste Auflagebereich (75) und / oder der zweite Auflagebereich (85) jeweils ein Plateau umfassen und die Plateaus an der Oberfläche von der Passivierungsschicht (50) ausbildet sind und die Steuerelektrode auf den Plateaus aufliegt.

14. Halbleiter-Gassensor (10) nach einem der Ansprüche 1 bis 13, **dadurch gekennzeichnet, dass** die Steuerelektrode ausschließlich auf dem der ersten Auflagebereich (75) und dem zweiten Auflagebereich (85) aufliegt und ausschließlich von dem ersten Verbindungsmittel (130) und / oder von dem zweiten Verbindungsmittel (140) gehalten wird.

## Claims

1. Semiconductor gas sensor (10) on the basis of an integrated field effect transistor with a semiconductor body (20) with a passivating layer (30) formed at the surface of the semiconductor body (20),
- which comprises a gas-sensitive control electrode separated by a gap from a channel region and which is constructed as a suspended gate field effect transistor (SGFET), or
- the control electrode (100) is arranged as a first plate of a capacitor with a gap and a second plate of the capacitor is connected with a gate of the field effect transistor constructed to be capacitively controlled (CCFET), and
the control electrode (100) comprises a semiconductor carrier layer with an adhesion promoting layer (122) thereon and a gas-sensitive layer (120) on the adhesion promoting layer, and
- the surface of the gas-sensitive layer (120) faces the channel region (55) or the second plate, and
- a support region with a first carrying structure (70) with a first deposit region (75) and a second carrying structure (80) with a second deposit region (85) are provided, wherein the control electrode (100) lies on the first deposit region (75),
**characterised in that**
a connecting region is provided on the surface of the semiconductor body (20) and the support region adjoins the connecting region, wherein the connecting region has a first connecting region and a second connecting region, the first connecting region has a first shaping (112) penetrating the passivating layer (30), the first shaping has a base surface with a conductive layer (115) to which a reference potential is applied, the first connecting region has an electrical connection and a non-positive connection with the control electrode (100) by way of first connecting means (130), the second connecting region has at least one non-positive connection with the control electrode (100) by way of second connecting means (140), and the first connecting means (13) at least partly fills the shaping and connects the control electrode (100) with the conductive layer (115).

2. Semiconductor gas sensor (10) according to claim 1, **characterised in that** the control electrode (100) is spaced from the connecting region in the direction of the normal vector of the semiconductor surface and at least partly covers the connecting region.

3. Semiconductor gas sensor (10) according to claim 1 or claim 2, **characterised in that** the second connecting region (140) has a second shaping (114), which penetrates the passivating layer (30), with a base surface and a conductive layer is formed at the base surface and the first connecting means (130) electrically connects the control electrode (100) with the conductive layer.

4. Semiconductor gas sensor (10) according to claim 3, **characterised in that** a frusto-conical elevation is formed on the base surface.

5. Semiconductor gas sensor (10) according to claim 4, **characterised in that** a plurality of frusto-conical elevations is formed on the base surface.

6. Semiconductor gas sensor (10) according to claim 4 or claim 5, **characterised in that** the elevation is constructed as a tungsten plug (150).

7. Semiconductor gas sensor (10) according to any one of claims 3 to 6, **characterised in that** the conductive layer contains silicon.

8. Semiconductor gas sensor (10) according to any one of claims 3 to 7, **characterised in that** the conductive layer is constructed from a doped polysilicon layer (115) and a silicide layer.

9. Semiconductor gas sensor (10) according to any one of the preceding claims, **characterised in that** the first connecting means (130) and the second connecting means (140) contain a conductive adhesive.

10. Semiconductor gas sensor (10) according to any one of any one of the preceding claims, **characterised in that** the first connecting means (130) and the second connecting means (140) are arranged exclusively below the control electrode (100) and at the outer side of the control electrode (100).

11. Semiconductor gas sensor (10) according to any one of the preceding claims, **characterised in that** the first connecting region directly adjoins the first carrier structure (70).

12. Semiconductor gas sensor (10) according to any one of claims 3 to 11, **characterised in that** the first connecting means (130) and/or the second connecting means (140) completely fills or fill the first shaping (112) and the second shaping (114).

13. Semiconductor gas sensor (10) according to any one of claims 1 to 12, **characterised in that** the first deposit region (75) and/or the second deposit region (85) comprises or each comprise a plateau and the or each plateau is formed at the surface of the passivating layer (50) and the control electrode lies on the plateau or plateaus.

14. Semiconductor gas sensor (10) according to any one of claims 1 to 13, **characterised in that** the control electrode lies exclusively on the first deposit region (75) and the second deposit region (85) and is held exclusively by the first connecting means (130) and/or by the second connecting means (140).

## Revendications

1. Capteur de gaz à semi-conducteur (10) sur la base d'un transistor à effet de champ intégré avec un corps semi-conducteur (20) avec une couche de passivation (30) formée sur la surface du corps semi-conducteur (20),
- qui présente une électrode de commande sensible au gaz séparée d'une région de canal par une fente et qui est réalisé sous la forme d'un transistor à effet de champ à grille suspendue (SGFET), ou
- l'électrode de commande (100) est disposée comme une première plaque d'un condensateur avec une fente et une deuxième plaque du condensateur est reliée à une grille du transistor à effet de champ réalisé sous forme contrôlée capacitivement (CCFET), et
l'électrode de commande (100) présente une couche de support de semi-conducteur avec une couche d'adhésif (122) appliquée et une couche sensible au gaz (120) appliquée sur la couche d'adhésif, et
- la surface de la couche sensible au gaz (120) est tournée vers la région de canal (55) ou vers la deuxième plaque, et
- il est prévu une région de soutien avec une première structure porteuse (70) avec une première zone d'appui (75) et une deuxième structure porteuse (80) avec une deuxième zone d'appui (85), dans lequel l'électrode de commande (100) repose sur la première zone d'appui (75),
**caractérisé en ce qu'**il est prévu une région de raccordement sur la surface du corps semi-conducteur (20) et la zone de soutien est adjacente à la région de raccordement, et la région de raccordement présente une première zone de raccordement et une deuxième zone de raccordement et la première zone de raccordement comprend une première protubérance (112) traversant la couche de passivation (30) et la première protubérance présente une face de base avec une couche conductrice (115) connectée à un potentiel de référence et la première zone de raccordement présente une liaison électrique et une liaison par adhérence avec l'électrode de commande (100) au moyen d'un premier moyen de liaison (130) et la deuxième zone de raccordement présente au moins une liaison par adhérence avec l'électrode de commande (100) au moyen d'un deuxième moyen de liaison (140), et le premier moyen de liaison (130) remplit au moins partiellement la protubérance et relie l'électrode de commande (100) à la couche conductrice (115).

2. Capteur de gaz à semi-conducteur (10) selon la revendication 1, **caractérisé en ce que** l'électrode de commande (100) est espacée de la région de raccordement dans la direction du vecteur normal à la surface du semi-conducteur et recouvre au moins partiellement la région de raccordement.

3. Capteur de gaz à semi-conducteur (10) selon la revendication 1 ou la revendication 2, **caractérisé en ce que** la deuxième zone de raccordement (140) présente une deuxième protubérance (114) traversant la couche de passivation (30) et une couche conductrice est formée sur la face de base et le premier moyen de liaison (130) relie électriquement l'électrode de commande (100) à la couche conductrice.

4. Capteur de gaz à semi-conducteur (10) selon la revendication 3, **caractérisé en ce qu'**une surélévation tronconique est formée sur la face de base.

5. Capteur de gaz à semi-conducteur (10) selon la revendication 4, **caractérisé en ce qu'**une multiplicité de surélévations tronconiques sont formées sur la face de base.

6. Capteur de gaz à semi-conducteur (10) selon la revendication 4 ou la revendication 5, **caractérisé en ce que** la surélévation est constituée par un barreau de tungstène (150).

7. Capteur de gaz à semi-conducteur (10) selon l'une quelconque des revendications 3 à 6, **caractérisé en ce que** la couche conductrice contient du silicium.

8. Capteur de gaz à semi-conducteur (10) selon l'une quelconque des revendications 3 à 7, **caractérisé en ce que** la couche conductrice est formée d'une couche de polysilicium dopé (115) et d'une couche de siliciure.

9. Capteur de gaz à semi-conducteur (10) selon l'une quelconque des revendications précédentes, **caractérisé en ce que** le premier moyen de liaison (130) et le deuxième moyen de liaison (140) contient une colle conductrice.

10. Capteur de gaz à semi-conducteur (10) selon l'une quelconque des revendications précédentes, **caractérisé en ce que** le premier moyen de liaison (130) et le deuxième moyen de liaison (140) est disposé exclusivement en dessous de l'électrode de commande (100) et sur le côté extérieur de l'électrode de commande (100).

11. Capteur de gaz à semi-conducteur (10) selon l'une quelconque des revendications précédentes, **caractérisé en ce que** la première zone de raccordement est directement adjacente à la première structure porteuse (70).

12. Capteur de gaz à semi-conducteur (10) selon l'une quelconque des revendications 3 à 11, **caractérisé en ce que** le premier moyen de liaison (130) et/ou le deuxième moyen de liaison (140) remplit entièrement la première protubérance (112) et la deuxième protubérance (114).

13. Capteur de gaz à semi-conducteur (10) selon l'une quelconque des revendications 1 à 12, **caractérisé en ce que** la première zone d'appui (75) et/ou la deuxième zone d'appui (85) comprennent respectivement un plateau et les plateaux sont formés sur la surface de la couche de passivation (50) et l'électrode de commande (100) repose sur les plateaux.

14. Capteur de gaz à semi-conducteur (10) selon l'une quelconque des revendications 1 à 13, **caractérisé en ce que** l'électrode de commande repose exclusivement sur la première zone d'appui (75) et la deuxième zone d'appui (85) et elle est maintenue exclusivement par le premier moyen de liaison (130) et/ou par le deuxième moyen de liaison (140).
